# EUROPÄISCHE PATENTSCHRIFT

(11) **EP 3 943 954 B1**
(45) Veröffentlichungstag und Bekanntmachung des Hinweises auf die Patenterteilung: **03.07.2024**
(21) Anmeldenummer: 20186688.6
(22) Anmeldetag: 20.07.2020
(51) Int. Cl.: G01R 27/18, G01R 31/08, G01R 31/52

(54) **SCHALTUNGSANORDNUNG ZUR LOKALISIERUNG VON ISOLATIONSFEHLERN**
CIRCUIT ARRANGEMENT FOR LOCATING INSULATION FAULTS
AGENCEMENT DE CIRCUIT PERMETTANT DE LOCALISER DES DÉFAUTS D'ISOLATION

(43) Veröffentlichungstag der Anmeldung: 26.01.2022
(73) Patentinhaber: Technische Universität Graz, 8010 Graz (AT); Austrian Power Grid AG, 1220 Wien (AT)
(72) Erfinder: Achleitner, Georg, 1150 Wien (AT); Weichinger, Günter, 3672 Maria Taferl (AT); Raffeiner, Erwin, 4230 Pregarten (AT); Hofer, Klaus, 2143 Grosskrut (AT); Fickert, Lothar, 8042 Graz St. Peter (AT)
(74) Vertreter: Patentanwaltskanzlei Matschnig & Forsthuber OG

(56) Entgegenhaltungen:
- EP-A1- 2 796 886
- DE-A1- 1 463 610
- DE-A1-102015 214 615

## Beschreibung

Die Erfindung betrifft eine Schaltungsanordnung zur Lokalisierung von Isolationsfehlern gegen Erde in isolierten Wechselspannungsnetzen bis 750V (Effektivwert), bei welcher die Spannung einer Wechselspannungsquelle an zwei Einspeiseleiter des zumindest zwei Abzweige aufweisenden Wechselspannungsnetzes gelegt ist.

Wechselspannungsnetze finden aufgrund der einfachen und effizienten Transformierbarkeit von Spannungsniveaus und der damit verbundenen effizienten Energieübertragung weltweit Anwendung. Wechselspannungssysteme umfassen dabei in der Regel zumindest zwei Leitungen, wobei die Spannung zwischen diesen Leitungen mit einer bestimmten Frequenz typischerweise sinusförmig verläuft. Mehrphasensysteme, insbesondere Dreiphasensysteme, weisen dabei regelmäßig einen Sternpunkt auf, der ebenso über einen Leiter kontaktiert werden kann (sog. Neutralleiter) und in das Energieversorgungssystem einbezogen werden kann. Dieser Neutralleiter kann grundsätzlich geerdet werden. In einigen Anwendungsfällen ist es allerdings vorteilhaft, wenn dieser Neutralleiter nicht geerdet ist. Man spricht in diesem Zusammenhang von isolierten Wechselspannungs- bzw. Drehstromnetzen, nämlich IT-Netzen bzw. IT-Systeme (franz. "Isole Terre").

Die Auslegung des elektrischen Netzes, der Verbraucher sowie der Schutzmaßnahmen bestimmen damit Reaktionen auf Isolationsfehler gegen Erde (also eine elektrische Verbindung einer Phase mit Erdpotential). Je nach Anwendungsfall werden dabei unterschiedliche Anforderungen an die Selektivität, Schnelligkeit, Empfindlichkeit, Genauigkeit, Zuverlässigkeit, Unabhängigkeit und Wirtschaftlichkeit gestellt. Aus dem Dokument EP 2 796 886 A1 ist eine Schaltungsanordnung zum Lokalisieren von Isolationsfehlern in Gleichspannungsnetzen bekannt geworden. Dokument DE 10 2015 214615 A1 betrifft ein Verfahren sowie Vorrichtungen zur erweiterten Isolationsfehlersuche in einem IT-Netz.

Das Erkennen von Erdschlüssen in solchen Netzen gestaltete sich bisher äußerst schwierig. Zur globalen Erkennung von Isolationsfehlern gegen Erde in Wechselspannungsnetzen sind aus dem Stand der Technik einige Maßnahmen bekannt. Aus dem Stand der Technik sind Verfahren bekannt geworden, bei denen hierfür einzelne Abzweige des Netzes systematisch ein- und ausgeschaltet werden. Da die Abzweige während der Zeitdauer des Ausschaltens keine Versorgungsaufgaben übernehmen können, ist dieses Verfahren für Anwendungen, in denen abschaltungssensible Verbraucher über die Abzweige versorgt werden, nicht geeignet.

Alternativ dazu wurde ein Verfahren bekannt, bei dem durch Modulieren der Spannung der einzelnen Phasen gegenüber Erde versucht wird, den fehlerhaften Abzweig festzustellen. Bei diesem Verfahren wird durch eine elektronische Schaltung eine zusätzliche Messspannung in einzelne Leitungen eingespeist. Dadurch kann ein Isolationsfehler festgestellt werden. Mit Hilfe von Stromimpulsen wird versucht den fehlerhaften Abzweig zu finden. Der Nachteil bei diesem Verfahren liegt darin, dass eine aktive Einspeisung benötigt wird, und damit die die maximale Netzlänge begrenzt ist.

Weiters ist ein Verfahren bekannt, dass mittels Widerstandsnetzwerk die Spannung gegen Erde misst. Bei einer symmetrischen Messung (beide Phasen gegen Erde ungefähr ident) geht man von einem fehlerfreien Betrieb aus. Bei einer starken Unsymmetrie ist ein Fehler aufgetreten.

Diesen bekannten Maßnahmen zur Lokalisierung von Isolationsfehlern gegen Erde in Wechselspannungsnetzen ist dabei gemein, dass diese lediglich Kompromisse hinsichtlich der obig angeführten Anforderungen darstellen.

Die Suche nach anderen Lösungswegen - z.B. aus der Gleichstromtechnik - gestaltet sich bei Wechselspannungsnetzen äußerst schwierig, da durch den Wechselstrom zusätzliche Einflüsse durch Kapazitäten und Induktivitäten vorliegen. Beim Gleichstrom ist der Fehlerstrom nur von den Widerständen im Fehlerkreis abhängig. Beim Wechselstrom kommt zusätzlich noch der Einfluss der gesamten Netzkapaztitäten dazu, weshalb bisher keine erfolgreichen Adaptionen von Gleichstromsystemen vorliegen.

Eine Aufgabe der Erfindung besteht daher darin, eine Schaltungsanordnung zur Ortung von Isolationsfehlern gegen Erde in Wechselspannungsnetzen zu schaffen, welche einfach, zuverlässig, genau, kostengünstig und möglichst unabhängig realisierbar ist.

Diese Aufgabe wird mit einer Schaltungsanordnung der eingangs genannten Art gelöst, welche erfindungsgemäß einen Auswahlschalter zur wahlweisen Verbindung der Einspeiseleiter mit Erdpotential sowie eine jedem zu überprüfenden Abzweig zugeordnete Erfassungseinrichtung zum Erfassen einer Stromänderung in dem Abzweig aufweist, wobei zwischen der Wechselspannungsquelle und den Einspeiseleitern eine Fehlererkennungseinrichtung zur Erfassung und Auswertung von Netzparametern angeordnet ist, wobei die Fehlererkennungseinrichtung zum Vergleich von Ist-Werten der Netzparameter mit vorgebbaren Soll-Werten eingerichtet ist und dadurch den fehlerbehafteten Einspeiseleiter erkennt, und bei Eintritt einer vorgebbaren Abweichung von den Soll-Werten eine Ansteuerung für den Auswahlschalter von einem Ruhezustand in einen aktivierten Zustand versetzt, wobei die Ansteuerung die Verbindung des fehlerbehafteten Einspeiseleiter mit Erdpotential ausschließlich während der Dauer des aktivierten Zustands zulässt, wobei die Erfassungseinrichtungen mit einer Recheneinheit verbunden sind, der die durch die Erfassungseinrichtungen erfassten Messergebnisse zugeführt sind, wobei die Recheneinheit dazu eingerichtet ist, aus den Messergebnissen die Höhe des parasitären Erdstromes des jeweiligen Abzweiges abzuleiten, und durch Erfassung der Änderung des parasitären Erdstromes während der Zeitdauer der Erdung des fehlerbehafteten Einspeiseleiters den fehlerhaften Abzweig zu identifizieren. Der Erdstrom beinhaltet zusätzlich zu den ohmschen Anteilen auch einen variablen, von den parasitären Leitungskapazitäten abhängigen Anteil.

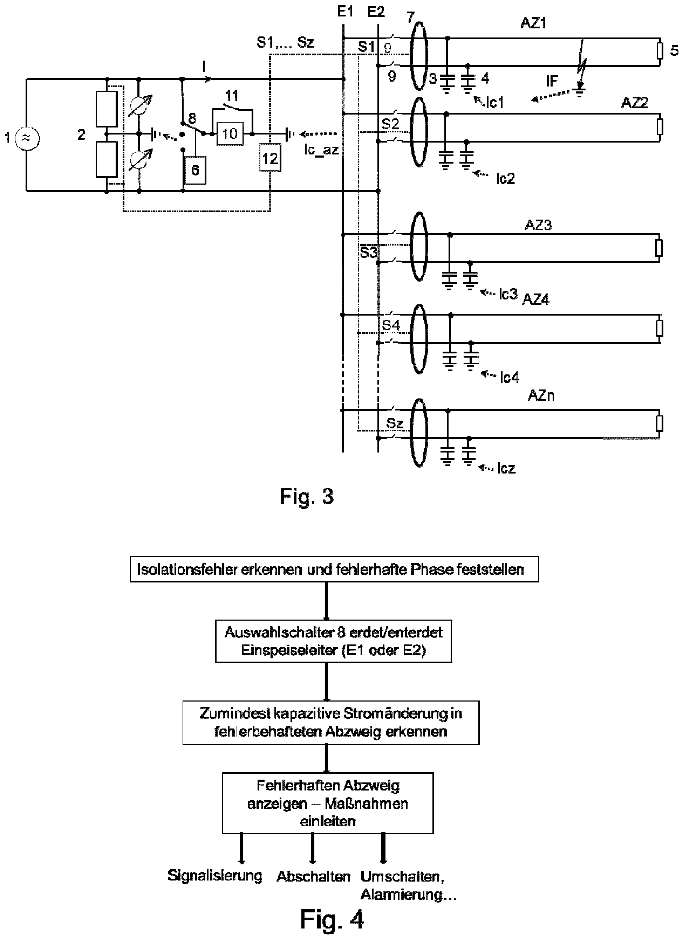

Beispielsweise kann die Fehlererkennung mit Blick auf Fig. 3 wie folgt erfolgen: Im Normalbetrieb sollte der Strom in den Leitern P1 und P2 (sozusagen Hin- und Rückleiter) ident sein. Jedoch sind die Leitungskapazitäten nicht exakt ident, weshalb es durch diese parasitären Kapazitäten zu einem gewissen Unterschied kommen kann. Dieser wird bereits durch die Erfassungseinrichtung erfasst. Die Größe ist schwer anzugeben, da dieser Wert von der Leitungslänge abhängig ist und daher individuell unterschiedlich sein kann. Der Strom über Erde wird sich sowohl auf die Fehlererkennungseinrichtung 2 als auch auf die anderen Leitungskapazitäten aufteilen. Sollte es nun zu einem Fehler kommen, wird der Fehlerstrom in Richtung aller Leitungskapazitäten der gesunden Phasen als auch zur Fehlererkennungseinrichtung 2 fließen. Die Erfassungseinrichtungen 7 werden nun überall Ströme erkennen, da die Summe der Hinleiter nicht mehr ident zu der Summe der Rückleiter ist (in einer Phase addiert sich nun der Strom der parasitären Kapazitäten). Im fehlerhaften Abzweig fließt der Strom über die Fehlerstelle zurück zur Quelle 1. Die Ströme sind abhängig vom Fehlerwiderstand. Bei einem Isolationsfehler von beispielsweise ca 40kOhm kann die Fehlererkennungseinrichtung 2 einen grundsätzlichen Fehler erkennen. Es ist, wieder abhängig von der Netzgröße, mit Fehlerströmen im mA-Bereich zu rechnen. Weiters fließt der Strom nun zusätzlich über die Fehlererkennungseinrichtung 2 retour in den gesunden Leiter. Man kann nun sowohl über die Erfassungseinrichtung 7 als auch die Fehlererkennungseinrichtung 2 den Fehlerstrom erfassen. Bei sehr hochohmigen Fehlern in der Größenordnung von einigen kOhm aufwärts, kann die Erfassung schwierig sein. Man hat ja bereits im Normalbetrieb unterschiedliche Ströme. Kommt es zu einem schleichenden Isolationsfehler, kann es sein, dass man sehr lange die Werte für Betriebswerte hält und auf einmal durch den Spannungsteiler ein Fehler angezeigt wird, den man durch die Erfassung der Ströme alleine nicht erkannt hat. Dafür hilft nun der Schalter 8. Durch diesen wird ein zusätzlicher Fehlerpunkt an einem definierten Ort eingelegt. Der Fehlerstrom wird jetzt aufgrund der geringeren Impedanz hauptsächlich über 8, dann das Erdungsnetz zur Fehlererkennungseinrichtung 2 fließen. Ein Teil wird auch über die restlichen Leitungskapazitäten fließen. Das Einlegen bzw. Wechseln von dem Schalter 8 bewirkt eine eindeutige Stromänderung in den Erfassungseinrichtungen 7, am stärksten in der, wo auch der Fehler besteht. Dies kann einfach erkannt und detektiert werden. Dadurch können auch sehr hochohmige Fehler gut erkannt werden.

Dank der Erfindung können Isolationsfehler kostengünstig und selektiv lokalisiert werden. Die erfindungsgemäße Schaltungsanordnung benötigt keine zusätzlichen Einspeisemittel, beugt durch Detektionsvorgänge verursachte Störungen der Verbraucher vor und zeichnet sich durch Langlebigkeit, eine hohe Genauigkeit und Zuverlässigkeit aus. Darüber hinaus ist die Funktionsweise der Erfindung äußerst robust und erlaubt eine Erkennung geringfügiger Fehlerströme und damit sehr hoher Fehlerwiderstände. Die Stromänderungen können durch eine direkte oder eine indirekte Messung erfasst werden. Die Erfindung berücksichtigt den Umstand, dass bei Wechselstromsystemen der Fehlerstrom im Gegensatz zu Gleichstromsystemen zusätzlich von der Netzgröße abhängig ist. Im Normalbetrieb kann z.B. durch eine unterschiedliche Leiter-Erde Kapazität des Hin- und Rückleiters bereits im fehlerfreien Betrieb eine kleine Asymmetrie auftreten. Diese wird im Fehlerfall verstärkt, kann jedoch trotzdem in jedem Abzweig sein (im Gegensatz zum Gleichstrom wo dies nur im fehlerhaften Abzweig auftritt). Die vorliegende Erfindung ermöglicht durch die nochmalige Erdung des fehlerbehafteten Einspeiseleiters eine eindeutige Erfassung des fehlerhaften Abzweiges. Dieser fehlerbehaftete Einspeiseleiter kann - wie bereits erwähnt - durch die Fehlererkennungseinrichtung identifiziert werden.

Unter dem Ausdruck "wahlweise Verbindung der Einspeiseleiter mit Erdpotential" wird dabei verstanden, dass auch nur ein Einspeiseleiter (also eine Phase) mit dem Erdpotential verbunden werden kann. Selbstverständlich kann auf eine Verbindung ("erden") eine Trennung ("enterden") folgen. Beispielsweise impliziert eine wahlweise Verbindung eines/ der Einspeiseleiter/s mit Erdpotential nach einer vorgebbaren zeitlichen Abfolge eine zwischenzeitliche/vorausgehende Trennung eines/der Einspeiseleiter/s von Erdpotential. Isolationsfehler gegen Erde, die in durch das Wechselspannungsnetz versorgten Verbrauchern auftreten, sind im Zuge dieser Anmeldung ebenso als dem Wechselspannungsnetz zugehörige Isolationsfehler zu betrachten.

Unter dem Begriff "Einspeiseleiter" wird z.B. eine Phase oder ein Neutralleiter verstanden. Die Messung der Änderung der Netzparameter während der Zeitdauer der Erdung bedeutet, dass die Änderung, die im Vergleich zu dem vorhergehenden ungeerdeten Zustand eintritt, erfasst wird. Dies funktioniert beim Neutralleiter in einem IT-Netz deshalb, da der Sternpunkt und damit auch das Netz nicht geerdet sind.

Insbesondere kann vorgesehen sein, dass die Fehlererkennungseinrichtung ein Widerstandsnetzwerk mit zumindest einer Spannungsmesseinrichtung ist. So kann beispielsweise das Widerstandsnetzwerk als ein von den Einspeiseleitern versorgter hochohmiger Spannungsteiler ausgebildet sein, wobei das Potential eines Referenzpunktes des Spannungsteilers mit dem Erdpotential verglichen wird.

Weiters kann vorgesehen sein, dass zwischen dem Auswahlschalter und dem Erdpotential ein mittels eines Hilfsschalters kurzschließbarer Hilfswiderstand vorgesehen ist. Auf diese Weise kann eine durch die Verbindung eines Einspeiseleiters mit Erdpotential verursachte Stromänderung einfach begrenzt werden

Wird anhand der erfindungsgemäßen Schaltungsanordnung ein Isolationsfehler gegen Erde in einem Abzweig entdeckt, so können entsprechende Maßnahmen zur Reaktion darauf veranlasst werden (die durch die Schaltungsanordnung ausgelöst werden können). So könnten Warnleuchten oder Signale aktiviert werden, ein Eintrag in einem Überwachungsprotokoll erstellt werden oder der Abzweig automatisch oder manuell abgeschaltet werden. Insbesondere kann vorgesehen sein, dass zumindest ein Abzweig durch die Erfassungseinrichtung steuerbare Leitungsschutzelemente aufweist. Damit kann der Abzweig automatisiert abgeschaltet werden.

Weiters kann vorgesehen sein, dass die Einspeiseleiter wahlweise, insbesondere wechselweise, mit Erdpotential verbunden werden und eine dadurch hervorgerufene kapazitive Änderung zumindest des Stromes in den Abzweigen erfasst und zur Feststellung des fehlerbehafteten Abzweigs herangezogen wird.

Weiters betrifft die Erfindung ein Verfahren zum Lokalisieren von Isolationsfehlern, bei welchem eine Wechselspannungsquelle Einspeiseleiter eines zumindest zwei Abzweige aufweisenden isolierten Wechselspannungsnetzes für Spannungen bis 750 V speist, wobei die Einspeiseleiter wahlweise mit Erdpotential verbunden werden und eine dadurch hervorgerufene kapazitive Änderung zumindest des Stromes in den Abzweigen erfasst und zur Feststellung des fehlerbehafteten Abzweigs herangezogen wird.

Erfindungsgemäß ist vorgesehen, dass zur Durchführung des Verfahrens eine jedem zu überprüfenden Abzweig zugeordnete Erfassungseinrichtung zum Erfassen einer Stromänderung in dem Abzweig vorgesehen ist, wobei zwischen der Wechselspannungsquelle und den Einspeiseleitern eine Fehlererkennungseinrichtung zur Erfassung und Auswertung von Netzparametern angeordnet ist, wobei die Fehlererkennungseinrichtung zum Vergleich von Ist-Werten der Netzparameter mit vorgebbaren Soll-Werten eingerichtet ist und dadurch den fehlerbehafteten Einspeiseleiter erkennt, und bei Eintritt einer vorgebbaren Abweichung von den Soll-Werten eine Ansteuerung für den Auswahlschalter von einem Ruhezustand in einen aktivierten Zustand versetzt, wobei die Ansteuerung die Verbindung des fehlerbehafteten Einspeiseleiter mit Erdpotential ausschließlich während der Dauer des aktivierten Zustands zulässt, wobei die Erfassungseinrichtungen mit einer Recheneinheit verbunden sind, der die durch die Erfassungseinrichtungen erfassten Messergebnisse zugeführt sind, wobei die Recheneinheit dazu eingerichtet ist, aus den Messergebnissen die Höhe zumindest des kapazitiven parasitären Erdstromes des jeweiligen Abzweiges abzuleiten, und durch Erfassung der Änderung zumindest des kapazitiven parasitären Erdstromes während der Zeitdauer der Erdung des fehlerbehafteten Einspeiseleiters den fehlerhaften Abzweig zu identifizieren. Selbstverständlich können die Erfassungseinrichtung und die Recheneinheit dazu eingerichtet sein, zudem auch ohmsche und/oder induktive Anteile des Erdstromes zu erfassen und zusätzlich auszuwerten.

Weiters kann vorgesehen sein, dass die erfasste Änderung zumindest des Stromes nach vorgebbaren Kriterien geprüft wird und ergebnisabhängig davon den Abzweigen zugeordnete Leitungsschutzmechanismen gesteuert werden.

Insbesondere kann vorgesehen sein, dass die erfasste Änderung zumindest des Stromes nach vorgebbaren Kriterien geprüft wird und ergebnisabhängig davon den Abzweigen zugeordnete Leitungsschutzmechanismen die Abzweige automatisch von den Einspeiseleitern trennen. Bei der Erkennung des fehlerhaften Abzweiges kann damit automatisch der fehlerhafte Abzweig getrennt werden. Dadurch wird im restlichen Netz wieder ein fehlerfreier Zustand hergestellt. Weiters ist damit auch die Fehlerstelle ohne Strom.

Weiters kann vorgesehen sein, dass Verfahren, dass die Verbindung des jeweiligen Einspeiseleiters mit Erdpotential nach einer vorgebbaren zeitlichen Abfolge erfolgt. So kann die Verbindung der jeweiligen Einspeiseleiter mit Erdpotential nach einem Muster, nach vorgebbaren Intervallen oder nach einem Takt erfolgen, die besonders gut zu Fehlererkennung geeignet sind.

Insbesondere kann vorgesehen sein, dass die zumindest zwei Einspeiseleiter auf Isolationsfehler gegen Erde geprüft werden, und dass erst nach Feststellung eines Isolationsfehlers gegen Erde die Einspeiseleiter wahlweise mit Erdpotential verbunden werden. Die Einspeiseleiter können, wie zuvor erwähnt, im Allgemeinen regelmäßig zu Testzwecken mit in einer vorgebbaren Abfolge mit Erdpotential verbunden werden. Es hat sich in der günstigen Realisierung allerdings als besonders vorteilhaft erwiesen, wenn die Einspeiseleiter ausschließlich nach Feststellung eines Isolationsfehlers gegen Erde nach einer vorgebbaren Abfolge mit Erdpotential verbunden werden. So können durch das Verfahren eingesetzte Bauteile sowie das Wechselspannungsnetz inklusive den Verbrauchern geschont werden und unerwünschte Einflüsse durch Potentialänderung der Einspeiseleiter minimiert werden.

Weiters kann vorgesehen sein, dass ausschließlich jener Einspeiseleiter mit Erdpotential verbunden wird, welcher den Isolationsfehler gegen Erde aufweist. Dies hat den Vorteil, dass eine durch die Verbindung mit dem Erdpotential verursachte Stromänderung einerseits ausreichend groß ist, um detektiert werden zu können, und andererseits ändert sich für die Verbraucher das Fehlerbild kaum, da bei einem bereits bestehenden Isolationsfehler einer Phase nur der Fehlerort "verschoben" wird, wodurch die Beeinflussung andere im Wechselspannungsnetz vorhandene Teilnehmer (einzelne Bauteile, Schutzeinrichtungen, Messeinrichtungen, Verbraucher) nicht gestört werden.

Die Erfindung samt weiteren Vorteilen ist im Folgenden anhand mehrerer beispielhafter und nicht einschränkender Ausführungsformen näher erläutert, die in den Figuren veranschaulicht sind. Dabei zeigen
Fig. 1 ein Ersatzschaltbild eines Wechselspannungsnetzes gemäß dem Stand der Technik,
Fig. 2 das Ersatzschaltbild des Wechselspannungsnetzes gemäß Fig. 1 im Fehlerfall,
Fig. 3 ein Ersatzschaltbild einer erfindungsgemäßen Schaltungsanordnung in einem Wechselspannungsnetz und
Fig. 4 ein Ablaufdiagramm eines erfindungsgemäßen Verfahrens.

Sofern nicht anders angegeben, werden in den Folgenden Figuren mit den gleichen Bezugszeichen die gleichen Komponenten bezeichnet.

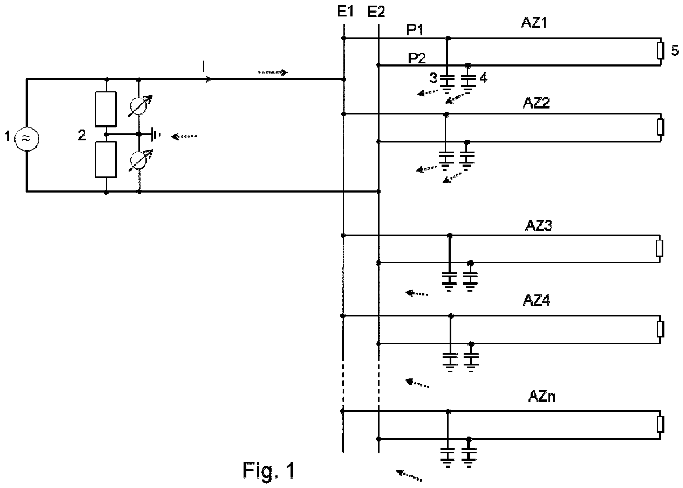

Fig. 1 zeigt ein Ersatzschaltbild eines aus dem Stand der Technik bekannten isolierten Wechselspannungsnetzes. Das Wechselspannungsnetz verfügt über zumindest eine Wechselspannungsquelle 1. Generell sind als Wechselspannungsquellen beliebige dem Fachmann bekannte Quellen geeignet, die das Wechselspannungsnetz mit Wechselspannung versorgen.

Die Wechselspannungsquelle 1 versorgt einen ersten und einen zweiten Einspeiseleiter (verbunden mit einer der Wechselspannungsquelle 1 zugeordneten ersten und/oder einer zweiten Phase P1 und/oder P2 oder einem Neutralleiter) E1 und E2, welche einzelne Abzweige AZ1, AZ2, ...AZn speisen. Die Abzweige AZ1, AZ2, ...AZn dienen zur Versorgung einzelner Verbraucher 5, wobei je nach Polarität ein Stromfluss von dem ersten Einspeiseleiter E1 über den Verbraucher 5 hin zum zweiten Einspeiseleiter E2 oder umgekehrt erfolgt. Ein Gesamtlastrom I teilt sich in einzelne in den Abzweigen AZ1, AZ2, ...Azn fließende Lastströme I1, I2,..., In auf. Die Abzweige AZ1, AZ2, ...AZn weisen zur Versorgung der Verbraucher 5 eine Hin- und eine Rückleitung mit jeweils einer Kapazität gegen Erde (bzw. Erdpotential) auf, welche durch Ersatzkapazitäten 3 und 4 repräsentiert werden. Die Anzahl der Abzweige AZ1, AZ2, ...AZn unterliegt im Allgemeinen keinen Einschränkungen und wird in der Praxis entsprechend der Einspeiseleistung, der Anzahl der Verbraucher 5 sowie der Netzeigenschaften passend gewählt. Die Abzweige AZ1, AZ2, ...AZn können sich durch die Anzahl der Verbraucher 5, ihre räumliche Ausdehnung, ihre Leitungseigenschaften, ihre Schutzelemente usw. unterscheiden. Zur übersichtlicheren Darstellung wurden nur in Abzweig AZ1 sämtliche relevante Bezugszeichen eingefügt. Diese Bezugszeichen gelten allerdings für die weiteren Abzweige AZ2, ...AZn in analoger Weise.

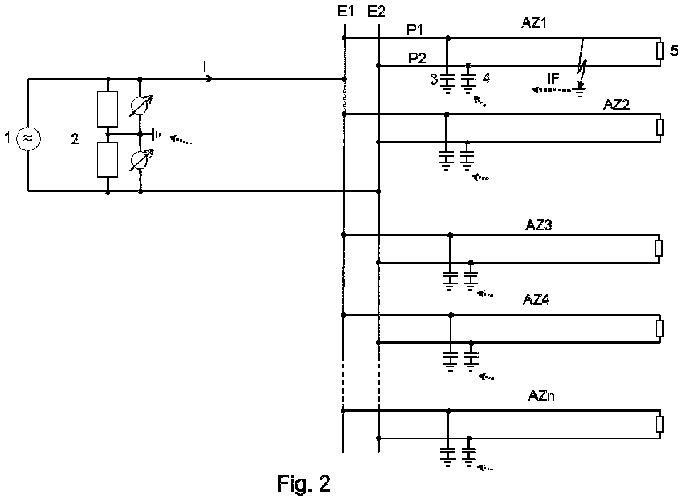

Zwischen der Wechselspannungsquelle 1 und den Einspeiseleitern E1 und E2 ist eine Fehlererkennungseinrichtung 2 eingerichtet, welche der Erkennung von Isolationsfehlern gegen Erde dient. Näheres dazu wird in der Beschreibung der Fig. 2 ausgeführt.

Fig. 2 zeigt das Ersatzschaltbild des Wechselspannungsnetzes gemäß Fig. 1 im Fehlerfall. Es handelt sich dabei um einen Isolationsfehler gegen Erde, welcher in der ersten Phase P1 im Abzweig AZ1 aufgetreten ist. Die erste Phase P1 nimmt somit Erdpotential an. Das (an sich isolierte) Wechselspannungsnetz ist in der gezeigten Ausführungsform zwar weiterhin funktionsfähig, jedoch besteht das Risiko, dass ein weiterer Isolationsfehler (in der zweiten Phase P2) das System aufgrund hoher Ströme und/oder einem Einbruch der Versorgungsspannung zum Ausfall bringt oder Benutzer durch Auftreten von Berührungsspannungen gefährdet werden. Die Erkennung von Isolationsfehlern gegen Erde ist daher von besonderer Bedeutung.

Hierfür misst die Fehlererkennungseinrichtung 2 die Spannungjen, die zwischen einem in einem Widerstandsnetzwerk geerdeten Knotenpunkt und dem ersten und/oder dem zweiten Einspeiseleiter E1 oder E2 (bzw. der damit verbundenen Phasen P1 oder P2) auftreten. Das Widerstandsnetzwerk ist dabei mit dem ersten und dem Einspeiseleiter E1 und E2 verbunden und der geerdete Knotenpunkt befindet sich innerhalb des Widerstandsnetzwerks und zwischen den beiden Einspeiseleitern E1 und E2. Im einfachsten Fall handelt es sich bei dem Widerstandsnetzwerk um zwei baugleiche hochohmige Widerstände, die in zwischen die Einspeiseleiter E1 und E2 in Serie geschaltet sind und somit im fehlerfreien Fall einen Spannungsteiler bilden, bei welchem jeweils 50% der zwischen den beiden Einspeiseleitern E1 und E2 auftretenden Differenzspannung an den einzelnen Widerständen anliegt. Der Punkt, an welchem die beiden Widerstände verbunden sind, ist dabei der zu erdende Punkt. Kommt also, wie in Fig. 2 dargestellt, die erste Phase P1 aufgrund eines Isolationsfehlers mit Erdpotential in Berührung, so nimmt die erste Phase P1 Erdpotential an und die Spannung zwischen dem Einspeiseleiter E1 bzw. der ersten Phase P1 und dem geerdeten Knotenpunkt der Fehlererkennungseinrichtung 2 senkt sich gegen 0V. Gleichzeitig erhöht sich die Spannung zwischen dem geerdeten Knotenpunkt und dem zweiten Einspeiseleiter E2 auf die volle, zwischen dem ersten und dem zweiten Einspeiseleiter E1 und E2 auftretende Differenzspannung. Zur Feststellung eines Isolationsfehlers reicht daher lediglich ein einziges Spannungsmessgerät bzw. Spannungsmesseinrichtung, die die Spannung zwischen einem Einspeiseleiter E1 oder E2 und dem geerdeten Knotenpunkt überwacht. Es ist allerdings aus Sicherheits- und Redundanzgründen vorteilhaft, wenn das Potential beider Einspeiseleiter E1 und E2 in Bezug auf den geerdeten Knotenpunkt überwacht wird. Ein Fehlerstrom IF fließt über die Fehlerstelle zu Erdpotential und überlagert sich dem Laststrom I. Aufgrund der Ersatzkapazität 4 und des Widerstandsnetzwerkes 2, fließt der Fehlerstrom IF vom Erdpotential zurück zu der Phase P2 bzw. dem Einspeiseleiter E2 (wie durch strichlierte Pfeilsymbole angedeutet wird). Die Höhe des Fehlerstromes IF ist dabei von dem Fehlerwiderstand und der Größe der Kapazitäten abhängig.

Diese Fehlererkennungseinrichtung 2 erlaubt eine zuverlässige Erkennung eines Isolationsfehlers einer Phase P1 oder P2 gegen Erde, kann allerdings keine Information über den Fehlerort zur Verfügung stellen. Eine Fehlersuche und Behebung ist daher vor allem bei umfangreich verzweigten Netzen besonders schwierig, wodurch für den Zeitraum des Fehlerauftritts die Betriebssicherheit des Wechselspannungsnetzes für einen längeren Zeitraum gefährdet sein kann oder das Wechselspannungsnetz generell abgeschaltet werden muss. Einzelne Abzweige AZ1, AZ2, ...AZn können dabei nicht gezielt untersucht und selektiv behandelt werden.

Fig. 3 veranschaulicht ein Ersatzschaltbild einer erfindungsgemäßen Schaltungsanordnung in einem isolierten Wechselspannungsnetz. Diese Schaltungsanordnung ist zur Lokalisierung von Isolationsfehlern gegen Erde in isolierten Wechselspannungsnetzen bis 750V eingerichtet.

Dabei ist die Spannung einer Wechselspannungsquelle 1 an zwei Einspeiseleiter E1, E2 des zumindest zwei Abzweige AZ1, AZ2, ...AZn aufweisenden Wechselspannungsnetzes gelegt. Die Schaltungsanordnung weist einen Auswahlschalter 8 zur wahlweisen Verbindung der Einspeiseleiter E1, E2 mit Erdpotential sowie eine jedem zu überprüfenden Abzweig 8-1, ..., 8-n zugeordnete Erfassungseinrichtung 7 zum Erfassen einer Stromänderung in dem Abzweig auf. Zwischen der Wechselspannungsquelle 1 und den Einspeiseleitern E1 und E2 ist eine Fehlererkennungseinrichtung 2 zur Erfassung und Auswertung von Netzparametern angeordnet, wobei die Fehlererkennungseinrichtung 2 zum Vergleich von Ist-Werten der Netzparameter mit vorgebbaren Soll-Werten eingerichtet ist und dadurch den fehlerbehafteten Einspeiseleiter E1, E2 erkennt, und bei Eintritt einer vorgebbaren Abweichung von den Soll-Werten eine Ansteuerung 5 für den Auswahlschalter 8 von einem Ruhezustand in einen aktivierten Zustand versetzt, wobei die Ansteuerung 5 die Verbindung des fehlerbehafteten Einspeiseleiter E1, E2 mit Erdpotential ausschließlich während der Dauer des aktivierten Zustands zulässt, wobei die Erfassungseinrichtungen 7 mit einer Recheneinheit 12 verbunden sind, der die durch die Erfassungseinrichtungen 7 erfassten Messergebnisse S1, S2, S3, S4, Sz zugeführt sind. Die Recheneinheit 12 ist dazu eingerichtet, aus den Messergebnissen S1, S2, S3, S4, Sz die Höhe des parasitären, insbesondere kapazitiven, Erdstromes Ic1, Ic2, Ic3, Ic4, Icz des jeweiligen Abzweiges 8-1, ..., 8-n abzuleiten, und durch Erfassung der Änderung des parasitären, insbesondere kapazitiven, Erdstromes Ic1, Ic2, Ic3, Ic4, Icz während der Zeitdauer der Erdung des fehlerbehafteten Einspeiseleiters E1, E2 den fehlerhaften Abzweig 8-1, ..., 8-n zu identifizieren. Dabei fließt natürlich auch dem geerdeten Knotenpunkt der Erfassungseinrichtung 2 und dem Erdungspunkt des Auswahlschalters 8 - abhängig von der Stellung des Schalters 8, jeweils Strom zu, wobei diese Ströme in ihrer Gesamtheit in Fig. 3 als Ic_az bezeichnet sind. Der Fehlerstrom IF teilt sich daher in die parasitären Ströme Ic1 bis Icz sowie Ic_az auf und fließt so ausgehend von dem fehlerbehafteten Abzweig AZ1 dem Einspeiseleiter E2 und damit der Energiequelle 1 zu. Diese Ströme können natürlich auch ohmsche - und gegebenenfalls auch induktive - Anteile haben, die ebenso erfasst und zur Fehlererkennung herangezogen werden können. Die ohmsche Komponente kann z.B. auch durch gezielte Wahl des ohmschen Widerstandes des Spannungsteilers der Vorrichtung 2 beeinflusst werden. Auch können die Ströme in den Widerständen des Spannungsteilers sowie der Strom, der über den Auswahlschalter 8 fließt, gemessen werden, und zusätzlich zur Bestimmung eines fehlerbehafteten Abzweiges herangezogen werden, wie dies in Fig. 3 beispielhaft durch strichlierte Linien dargestellt ist.

In Fig. 3 ist erkennbar, dass die Fehlererkennungseinrichtung 2 als ein Widerstandsnetzwerk mit zwei Spannungsmesseinrichtungen ausgebildet ist. Zudem kann in dieser Ausführungsform vorgesehen sein, dass zwischen dem Auswahlschalter 8 und dem Erdpotential ein mittels eines Hilfsschalters 11 kurzschließbarer Hilfswiderstand 10 vorgesehen ist. Ebenso kann vorgesehen sein, dass zumindest ein Abzweig AZ1 durch die Erfassungseinrichtung 7 steuerbare Leitungsschutzelemente 9 aufweist.

Weiters betrifft die Erfindung ein Verfahren zum Lokalisieren von Isolationsfehlern, bei welchem eine Wechselspannungsquelle 1 Einspeiseleiter E1, E2 eines zumindest zwei Abzweige AZ1, AZ2, ...AZn aufweisenden isolierten Wechselspannungsnetzes für Spannungen bis 750V speist, wobei die Einspeiseleiter E1, E2 wahlweise mit Erdpotential verbunden werden und eine dadurch hervorgerufene ohmsch/kapazitive Änderung zumindest des Stromes in den Abzweigen AZ1, AZ2, ...AZn erfasst und zur Feststellung des fehlerbehafteten Abzweigs AZ1, AZ2, ...AZn herangezogen wird. Wie bereits in Fig. 3 dargestellt wird, ist zur Durchführung des Verfahrens eine jedem zu überprüfenden Abzweig 8-1, ..., 8-n zugeordnete Erfassungseinrichtung 7 zum Erfassen einer Stromänderung in dem Abzweig vorgesehen ist, wobei zwischen der Wechselspannungsquelle 1 und den Einspeiseleitern E1, E2 eine Fehlererkennungseinrichtung 2 zur Erfassung und Auswertung von Netzparametern angeordnet ist, wobei die Fehlererkennungseinrichtung 2 zum Vergleich von Ist-Werten der Netzparameter mit vorgebbaren Soll-Werten eingerichtet ist und dadurch den fehlerbehafteten Einspeiseleiter E1, E2 erkennt, und bei Eintritt einer vorgebbaren Abweichung von den Soll-Werten eine Ansteuerung 5 für den Auswahlschalter 8 von einem Ruhezustand in einen aktivierten Zustand versetzt, wobei die Ansteuerung 5 die Verbindung des fehlerbehafteten Einspeiseleiter E1, E2 mit Erdpotential ausschließlich während der Dauer des aktivierten Zustands zulässt, wobei die Erfassungseinrichtungen 7 mit einer Recheneinheit 12 verbunden sind, der die durch die Erfassungseinrichtungen 7 erfassten Messergebnisse S1, S2, S3, S4, Sz zugeführt sind, wobei die Recheneinheit 12 dazu eingerichtet ist, aus den Messergebnissen S1, S2, S3, S4, Sz die Höhe des parasitären Erdstromes Ic1, Ic2, Ic3, Ic4, Icz des jeweiligen Abzweiges 8-1, ..., 8-n abzuleiten, und durch Erfassung der Änderung des parasitären Erdstromes Ic1, Ic2, Ic3, Ic4, Icz während der Zeitdauer der Erdung des fehlerbehafteten Einspeiseleiters E1, E2 den fehlerhaften Abzweig 8-1, ..., 8-n zu identifizieren.

Weiters soll zu Fig. 3 erwähnt werden, dass die Abzweige AZ1, AZ2, ...AZn darin über Leitungstrenn- oder Leitungsschutzelemente 9 verfügen, welche schützende Maßnahmen wie beispielsweise die Trennung einzelner Abzweige AZ1, AZ2, ...AZn von den Phasen P1 und P2 durchführen können. Zusätzlich verfügen zumindest jene Abzweige AZ1, AZ2, ... AZn, die durch die erfindungsgemäße Schaltungsanordnung überprüfbar sein sollen, über eine Erfassungseinrichtung 7. Diese Erfassungseinrichtung 7 ist zur Messung von Netzparametern eingerichtet, wobei beispielsweise zeitliche Änderungen dieser Netzparameter, z.B. der Kapazität einzelner Abzweige bzw. der kapazitiven Stromaufnahme dieser Abzweige dazu herangezogen werden, um auf einen Isolationsfehler gegen Erde innerhalb eines Abzweiges AZ1, AZ2, ...AZn rückschließen zu können.

Die Erfassungseinrichtung 7 wirkt in Verbindung mit einem Auswahlschalter 8, der dazu eingerichtet ist, wahlweise eine Verbindung einer der beiden Einspeiseleiter E1 und E2 mit Erde herzustellen. Der Auswahlschalter 8 befindet sich vorzugsweise zwischen der Wechselspannungsquelle 1 und den Einspeiseleitern E1 und E2. Die Leitungsschutzelemente 9, die Erfassungseinrichtung 7 sowie die Verbraucher 5 sind nachgeschaltet.

Das Wechselspannungsnetz gemäß Fig. 3 weist im Abzweig AZ1 analog zu Fig. 2 in der ersten Phase P1 einen Isolationsfehler gegen Erde auf. Verbindet der Auswahlschalter 8 im gezeigten Beispiel den ersten Einspeiseleiter E1 und somit die erste Phase P1 mit Erdpotential, so führt dies zu einer messbaren Stromänderung im fehlerbehafteten Abzweig AZ1, die durch die Erfassungseinrichtung 7 erfasst wird. Der Strom fließt nun nicht mehr nur über die Fehlerstelle gegen Erde sondern hauptsächlich über den Auswahlschalter 8, aufgrund des geringen Widerstandes zwischen Einspeisung und Erdstelle. Dadurch kommt es zu einer Stromänderung des Fehlerstromes IF. Der Vorteil ist zusätzlich dabei, dass es zu einer Entlastung der Fehlerstelle kommt, wodurch eine mögliche Gefährdung reduziert wird. Die Erfassung des zeitlichen Verlaufes der Stromänderung durch die Erfassungseinrichtung 7 kann beispielsweise durch eine Auswertung der Messwertänderung einer Summenstrommessung oder der Messung mittels eines Ringstromwandlers oder eines einer Rogowskispule erfolgen. Die Summenstrom- bzw. Stromänderungen (die als "Ortungsstrom/ströme" dienen) in den Abzweigen AZ1, AZ2, ...AZn können durch die jeweilig zugeordnete Erfassungseinrichtung 7 erkannt und ausgewertet werden. Eine mögliche Einschaltung eines Hilfs-Widerstandes 10 durch Öffnen eines Hilfs-Schalters 11 in den Strompfad zwischen dem Auswahlschalter 8 und Erde bewirkt eine fallweise zweckmäßige Begrenzung des Ortungsstromes.

Je nach Anwendung und Einstellung der Erfassungseinrichtung 7 kann zur Fehlererkennung ein Verbinden der der fehlerbehafteten Phase bzw. des fehlerbehafteten Neutralleiters mit Erdpotential erwünscht sein. Auch ist es denkbar, dass der Auswahlschalter 8 nur ausschließlich eine der beiden Phasen P1 bzw. P2 mit Erdpotential verbinden kann, der Auswahlschalter 8 also nur zwei Schaltstellungen bzw. Schaltzustände aufweist.

Die Erfassungseinrichtung 7 kann bei Erkennung eines Isolationsfehlers gegen Erde Warnleuchten und/oder andere Signale aktivieren, ein Eintrag in einem Überwachungsprotokoll erstellen oder den fehlerbehafteten Abzweig AZ1, AZ2 und/oder ...AZn automatisch oder nach manueller Bestätigung abschalten, indem die Leitungsschutzelemente 9 aktiviert werden.

Das wahlweise Erden bzw. Enterden eines fehlerbehafteten Einspeiseleiters E1 oder E2 bzw. einer Phase P1 oder P2 durch Verbinden bzw. Trennen des jeweiligen Einspeiseleiters mit Erdpotential nach einer vorgebbaren zeitlichen Abfolge mittels des Auswahlschalters 8 kann in einem vorgebbaren Zeitintervall (-muster) erfolgen. Besonders vorteilhaft ist es aber, wenn die Fehlererkennungseinrichtung 2 Ist-Werte der Netzparameter mit vorgebbaren Soll-Werten vergleicht und bei Eintritt einer vorgebbaren Abweichung von den Soll-Werten eine Ansteuerung 6 für den Auswahlschalter 8 von einem Ruhezustand in einen aktivierten Zustand versetzt, wobei die Ansteuerung 6 die wahlweise Verbindung der Einspeiseleiter E1 oder E2 ausschließlich während der Dauer des aktivierten Zustands zulässt.

Fig. 4 zeigt ein Ablaufdiagramm eines erfindungsgemäßen Verfahrens, nach welchem die Erkennung und Lokalisierung von Isolationsfehlern gegen Erde in Wechselspannungsnetzen erfolgt. Analog zu den obigen Ausführungen erdet der Auswahlschalter 8 wahlweise einen Einspeiseleiter E1 oder E2, wobei ohmsch/kapazitive Stromänderungen in den Abzweigen AZ1, AZ2, ...AZn erfasst werden. Wird eine signifikante Stromänderung festgestellt, so können geeignete Maßnahmen zur Anzeige oder zur Behebung des Fehlers vorgenommen werden, wie beispielsweise das Aktivieren von Warnleuchten oder anderen Signalen, das Erstellen von Einträgen in Überwachungsprotokollen, die Abschaltung des betroffenen Abzweiges AZ1, AZ2, ...AZn oder das Ergreifen sonstiger Maßnahmen. Zur Fehlererkennung ist dabei vorzugsweise die Fehlerkennungseinrichtung 2 vorgesehen, mit Hilfe derer die fehlerhafte Phase festgestellt werden kann.

Der dieser Erfindung zu Grunde liegende Gedanke kann in dem Fachmann bekannter Weise abgewandelt werden und ist für den Einsatz bei unterschiedlichen Formen von isolierten Wechselspannungsnetzen, insbesondere auch bei Drehspannungsnetzen, geeignet. Die Erfindung ist nicht auf die gezeigten Ausführungsformen beschränkt, sondern durch den gesamten Schutzumfang der Ansprüche definiert. Auch können einzelne Aspekte der Erfindung bzw. der Ausführungsformen aufgegriffen und miteinander kombiniert werden. Etwaige Bezugszeichen in den Ansprüchen sind beispielhaft und dienen nur der einfacheren Lesbarkeit der Ansprüche, ohne diese einzuschränken.

## Patentansprüche

1. Schaltungsanordnung zur Lokalisierung von Isolationsfehlern gegen Erde in isolierten Wechselspannungsnetzen bis 750V, bei welcher die Spannung einer Wechselspannungsquelle (1) an zwei Einspeiseleiter (E1, E2) des zumindest zwei Abzweige (AZ1, AZ2, ...AZn) aufweisenden Wechselspannungsnetzes gelegt ist,
aufweisend einen Auswahlschalter (8) zur wahlweisen Verbindung der Einspeiseleiter (E1, E2) mit Erdpotential sowie eine jedem zu überprüfenden Abzweig (8-1, ..., 8-n) zugeordnete Erfassungseinrichtung (7) zum Erfassen einer Stromänderung in dem Abzweig, wobei zwischen der Wechselspannungsquelle (1) und den Einspeiseleitern (E1, E2) eine Fehlererkennungseinrichtung (2) zur Erfassung und Auswertung von Netzparametern angeordnet ist, wobei die Fehlererkennungseinrichtung (2) zum Vergleich von Ist-Werten der Netzparameter mit vorgebbaren Soll-Werten eingerichtet ist und dadurch den fehlerbehafteten Einspeiseleiter (E1, E2) erkennt, und bei Eintritt einer vorgebbaren Abweichung von den Soll-Werten eine Ansteuerung (6) für den Auswahlschalter (8) von einem Ruhezustand in einen aktivierten Zustand versetzt, wobei die Ansteuerung (6) die Verbindung des fehlerbehafteten Einspeiseleiter (E1, E2) mit Erdpotential ausschließlich während der Dauer des aktivierten Zustands zulässt, wobei die Erfassungseinrichtungen (7) mit einer Recheneinheit (12) verbunden sind, der die durch die Erfassungseinrichtungen (7) erfassten Messergebnisse (S1, S2, S3, S4, Sz) zugeführt sind, wobei die Recheneinheit (12) dazu eingerichtet ist,
- aus den Messergebnissen (S1, S2, S3, S4, Sz) die Höhe zumindest des kapazitiven parasitären Erdstromes (Ic1, Ic2, Ic3, Ic4, Icz) des jeweiligen Abzweiges (8-1, ..., 8-n) abzuleiten, und
- durch Erfassung der Änderung zumindest des kapazitiven parasitären Erdstromes (Ic1, Ic2, Ic3, Ic4, Icz) während der Zeitdauer der Erdung des fehlerbehafteten Einspeiseleiters (E1, E2) den fehlerhaften Abzweig (8-1, ..., 8-n) zu identifizieren.

2. Schaltungsanordnung nach Anspruch 1, wobei die Fehlererkennungseinrichtung (2) ein Widerstandsnetzwerk mit zumindest einer Spannungsmesseinrichtung ist.

3. Schaltungsanordnung nach Anspruch 1, wobei zwischen dem Auswahlschalter (8) und dem Erdpotential ein mittels eines Hilfsschalters (11) kurzschließbarer Hilfswiderstand (10) vorgesehen ist.

4. Schaltungsanordnung nach einem der vorhergehenden Ansprüche, wobei zumindest ein Abzweig (AZ1) durch die Erfassungseinrichtung (7) steuerbare Leitungsschutzelemente (9) aufweist.

5. Schaltungsanordnung nach einem der vorhergehenden Ansprüche, wobei die Erfassungseinrichtungen (7) und die Recheneinheit (12) dazu eingerichtet sind, zudem auch ohmsche und/oder induktive Anteile des parasitären Erdstromes zu erfassen und zur Fehlererkennung heranzuziehen

6. Verfahren zum Lokalisieren von Isolationsfehlern, bei welchem eine Wechselspannungsquelle (1) Einspeiseleiter (E1, E2) eines zumindest zwei Abzweige (AZ1, AZ2, ...AZn) aufweisenden isolierten Wechselspannungsnetzes für Spannungen bis 750V speist, wobei die Einspeiseleiter (E1, E2) wahlweise mit Erdpotential verbunden werden und eine dadurch hervorgerufene zumindest kapazitive Änderung zumindest des Stromes in den Abzweigen (AZ1, AZ2, ...AZn) erfasst und zur Feststellung des fehlerbehafteten Abzweigs (AZ1, AZ2, ...AZn) herangezogen wird, wobei zur Durchführung des Verfahrens eine jedem zu überprüfenden Abzweig (8-1, ..., 8-n) zugeordnete Erfassungseinrichtung (7) zum Erfassen einer Stromänderung in dem Abzweig vorgesehen ist, wobei zwischen der Wechselspannungsquelle (1) und den Einspeiseleitern (E1, E2) eine Fehlererkennungseinrichtung (2) zur Erfassung und Auswertung von Netzparametern angeordnet ist, wobei die Fehlererkennungseinrichtung (2) zum Vergleich von Ist-Werten der Netzparameter mit vorgebbaren Soll-Werten eingerichtet ist und dadurch den fehlerbehafteten Einspeiseleiter (E1, E2) erkennt, und bei Eintritt einer vorgebbaren Abweichung von den Soll-Werten eine Ansteuerung (6) für den Auswahlschalter (8) von einem Ruhezustand in einen aktivierten Zustand versetzt, wobei die Ansteuerung (6) die Verbindung des fehlerbehafteten Einspeiseleiter (E1, E2) mit Erdpotential ausschließlich während der Dauer des aktivierten Zustands zulässt, wobei die Erfassungseinrichtungen (7) mit einer Recheneinheit (12) verbunden sind, der die durch die Erfassungseinrichtungen (7) erfassten Messergebnisse (S1, S2, S3, S4, Sz) zugeführt sind, wobei die Recheneinheit (12) dazu eingerichtet ist,
- aus den Messergebnissen (S1, S2, S3, S4, Sz) die Höhe zumindest des kapazitiven parasitären Erdstromes (Ic1, Ic2, Ic3, Ic4, Icz) des jeweiligen Abzweiges (8-1, ..., 8-n) abzuleiten, und
- durch Erfassung der Änderung zumindest des kapazitiven parasitären Erdstromes (Ic1, Ic2, Ic3, Ic4, Icz) während der Zeitdauer der Erdung des fehlerbehafteten Einspeiseleiters (E1, E2) den fehlerhaften Abzweig (8-1, ..., 8-n) zu identifizieren.

7. Verfahren nach Anspruch 6, wobei die erfasste Änderung zumindest des Stromes nach vorgebbaren Kriterien geprüft wird und ergebnisabhängig davon den Abzweigen (AZ1, AZ2, ...AZn) zugeordnete Leitungsschutzmechanismen gesteuert werden.

8. Verfahren nach Anspruch 7, wobei die erfasste Änderung zumindest des Stromes nach vorgebbaren Kriterien geprüft wird und ergebnisabhängig davon den Abzweigen (AZ1, AZ2, ...AZn) zugeordnete Leitungsschutzmechanismen die Abzweige (AZ1, AZ2, ...AZn) automatisch von den Einspeiseleitern (E1, E2) trennen.

9. Verfahren nach einem der Ansprüche 6 bis 8, wobei die Verbindung des jeweiligen Einspeiseleiters (E1, E2) mit Erdpotential nach einer vorgebbaren zeitlichen Abfolge erfolgt.

10. Verfahren nach einem der Ansprüche 6 bis 8, wobei die zumindest zwei Einspeiseleiter (E1, E2) auf Isolationsfehler gegen Erde geprüft werden, und dass erst nach Feststellung eines Isolationsfehlers gegen Erde die Einspeiseleiter (E1, E2) wahlweise mit Erdpotential verbunden werden.

11. Verfahren nach Anspruch 10, wobei ausschließlich jener Einspeiseleiter (E1, E2) mit Erdpotential verbunden wird, welcher den Isolationsfehler gegen Erde aufweist.

12. Verfahren nach einem der Ansprüche 6 bis 11, **dadurch gekennzeichnet, dass** die Erfassungseinrichtungen (7) und die Recheneinheit (12) dazu eingerichtet sind, zudem auch ohmsche und/oder induktive Anteile des parasitären Erdstromes zu erfassen und zur Fehlererkennung heranzuziehen.

## Claims

1. Circuit arrangement for localizing insulation faults to earth in insulated AC voltage systems up to 750 V, in which the voltage of an AC voltage source (1) is applied to two feed conductors (E1, E2) of the AC voltage system having at least two feeders (AZ1, AZ2, ... AZn),
having a selection switch (8) for selectively connecting the feed conductors (E1, E2) to earth potential and a detection device (7) assigned to each branch (8-1, ... 8-n) to be checked for detecting a current change in the feeder, wherein a fault detection device (2) for detecting and evaluating network parameters is arranged between the AC voltage source (1) and the feed conductors (E1, E2), wherein the fault detection device (2) is set up for comparing actual values of the network parameters with predeterminable setpoint values and thereby recognizes the faulty feed conductor (E1, E2), and when a predeterminable deviation from the setpoint values occurs, an actuation (6) for the selection switch (8) is set from a rest state to an activated state, wherein the actuation (6) ensures the connection of the faulty feed conductor (E1, E2) to earth potential exclusively during the duration of the activated state, the detection devices (7) being connected to a computing unit (12) to which the measurement results (S1, S2, S3, S4, Sz) detected by the detection devices (7) are fed, the computing unit (12) being configured to
- derive from the measurement results (S1, S2, S3, S4, Sz) the level of at least the capacitive parasitic earth current (Id, Ic2, Ic3, Ic4, Icz) of the respective feeder (8-1, ..., 8-n), and
- identify the faulty feeder (8-1, ..., 8-n) by detecting the change in at least the capacitive parasitic earth current (Ic1, Ic2, Ic3, Ic4, Icz) during the period of earthing of the faulty feeder conductor (E1, E2).

2. Circuit arrangement according to claim 1, wherein the fault detection device (2) is a resistor network with at least one voltage measuring device.

3. Circuit arrangement according to claim 1, wherein an auxiliary resistor (10) which can be shortcircuited by means of an auxiliary switch (11) is provided between the selection switch (8) and the earth potential.

4. Circuit arrangement according to one of the preceding claims, wherein at least one branch (AZ1) has line protection elements (9) controllable by the detection device (7).

5. Circuit arrangement according to one of the preceding claims, wherein the detection devices (7) and the computing unit (12) are configured to also detect resistive and/or inductive components of the parasitic earth current and to use them for fault detection.

6. Method for localizing insulation faults, in which an AC voltage source (1) feeds supply conductors (E1, E2) of an insulated AC voltage network having at least two feeders (AZ1, AZ2, ...AZn) for voltages up to 750V, the supply conductors (E1, E2) being optionally connected to earth potential and an at least capacitive change caused thereby at least in the current in the feeders (AZ1, AZ2, ... AZn) is detected and used to determine the faulty feeder (AZ1, AZ2, ...AZn),
wherein, in order to carry out the method, a detection device (7) associated with each feeder (8-1, ... 8-n) to be checked is provided for detecting a current change in the feeder, a fault detection device (2) for detecting and evaluating network parameters being arranged between the AC voltage source (1) and the feed conductors (E1, E2), the fault detection device (2) being set up for comparing actual values of the network parameters with predeterminable setpoint values and thereby recognizing the faulty feed conductor (E1, E2), and when a predeterminable deviation from the setpoint values occurs, an actuation (6) for the selection switch (8) is set from a rest state to an activated state, wherein the actuation (6) ensures the connection of the faulty feed conductor (E1, E2) to earth potential exclusively during the duration of the activated state, the detection devices (7) being connected to a computing unit (12) to which the measurement results (S1, S2, S3, S4, Sz) detected by the detection devices (7) are fed, the computing unit (12) being configured to
- derive the level of at least the capacitive parasitic earth current (Id, Ic2, Ic3, Ic4, Icz) of the respective branch (8-1, ..., 8-n) from the measurement results (S1, S2, S3, S4, Sz), and
- identify the faulty feeder (8-1, ..., 8-n) by detecting the change in at least the capacitive parasitic earth current (Ic1, Ic2, Ic3, Ic4, Icz) during the period of earthing of the faulty feeder conductor (E1, E2).

7. Method according to claim 6, wherein the detected change in at least the current is checked according to predeterminable criteria and line protection mechanisms assigned to the feeders (AZ1, AZ2, ...AZn) are controlled depending on the result thereof.

8. Method according to claim 7, wherein the detected change in at least the current is checked according to predeterminable criteria and line protection mechanisms assigned to the feeders (AZ1, AZ2, ...AZn) automatically disconnect the feeders (AZ1, AZ2, ...AZn) from the feed conductors (E1, E2) depending on the result thereof.

9. Method according to one of claims 6 to 8, wherein the connection of the respective feed conductor (E1, E2) to earth potential takes place according to a predeterminable time sequence.

10. Method according to one of claims 6 to 8, wherein the at least two feed conductors (E1, E2) are tested for insulation faults to earth, and that the feed conductors (E1, E2) are optionally connected to earth potential only after an insulation fault to earth has been detected.

11. Method according to claim 10, wherein only that feed conductor (E1, E2) is connected to earth potential which has the insulation fault to earth.

12. Method according to one of claims 6 to 11, **characterized in that** the detection devices (7) and the computing unit (12) are also set up to detect resistive and/or inductive components of the parasitic earth current and to use them for fault detection.

## Revendications

1. Circuit pour la localisation de défauts d'isolation par rapport à la terre dans des réseaux de tension alternative isolés jusqu'à 750V, dans lequel la tension d'une source de tension alternative (1) est appliquée à deux conducteurs d'alimentation (E1, E2) du réseau de tension alternative présentant au moins deux dérivations (AZ1, AZ2, ...AZn), présentant un commutateur de sélection (8) pour relier sélectivement les conducteurs d'alimentation (E1, E2) au potentiel de terre ainsi qu'un dispositif de détection (7) associé à chaque dérivation à contrôler (8-1, ..., 8-n) pour détecter une variation de courant dans la dérivation, un dispositif de détection de défaut (2) étant disposé entre la source de tension alternative (1) et les conducteurs d'alimentation (E1, E2) pour détecter et évaluer des paramètres de réseau, le dispositif de détection de défaut (2) étant conçu pour comparer des valeurs réelles des paramètres de réseau avec des valeurs de consigne pouvant être prédéfinies et pour détecter ainsi le conducteur d'alimentation (E1, E2) défectueux, et, en cas de survenance d'un écart pouvant être prédéfini par rapport aux valeurs de consigne, fait passer une commande (6) pour le commutateur de sélection (8) d'un état de repos à un état activé, la commande (6) interrompant la liaison du conducteur d'alimentation défectueux (E1, E2) au potentiel de terre exclusivement pendant la durée de l'état activé, les dispositifs de détection (7) étant reliés à une unité de calcul (12) à laquelle sont transmis les résultats de mesure (S1, S2, S3, S4, Sz) détectés par les dispositifs de détection (7), l'unité de calcul (12) étant adaptée pour
- déduire des résultats de mesure (S1, S2, S3, S4, Sz) la valeur d'au moins le courant de terre parasite capacitif (Ic1, Ic2, Ic3, Ic4, Icz) de la dérivation respective (8-1, ..., 8-n), et
- identifier la dérivation (8-1, ..., 8-n) en défaut en détectant la variation d'au moins le courant capacitif parasite de terre (Ic1, Ic2, Ic3, Ic4, Icz) pendant la durée de mise à la terre du conducteur d'alimentation (E1, E2) en défaut.

2. Circuit selon la revendication 1, dans lequel le dispositif de détection de défaut (2) est un réseau de résistances comprenant au moins un dispositif de mesure de tension.

3. Circuit selon la revendication 1, dans lequel une résistance auxiliaire (10) pouvant être court-circuitée au moyen d'un interrupteur auxiliaire (11) est prévue entre le commutateur de sélection (8) et le potentiel de terre.

4. Circuit selon l'une des revendications précédentes, dans lequel au moins une dérivation (AZ1) comporte des éléments de protection de ligne (9) pouvant être commandés par le dispositif de détection (7).

5. Circuit selon l'une des revendications précédentes, dans lequel les dispositifs de détection (7) et l'unité de calcul (12) sont adaptés pour détecter également les composantes ohmiques et/ou inductives du courant de terre parasite et les utiliser pour la détection des défauts.

6. Procédé pour localiser des défauts d'isolation, dans lequel une source de tension alternative (1) alimente des conducteurs d'alimentation (E1, E2) d'un réseau de tension alternative isolé présentant au moins deux dérivations (AZ1, AZ2, ... AZn) pour des tensions allant jusqu'à 750 V, les conducteurs d'alimentation (E1, E2) étant reliés au choix au potentiel de terre et une modification au moins capacitive ainsi provoquée au moins du courant dans les dérivations (AZ1, AZ2, ... AZn) étant détectée et utilisée pour déterminer la dérivation (AZ1, AZ2, ... AZn) défectueuse, dans lequel, pour la mise en oeuvre du procédé, une valeur de consigne est attribuée à chaque dérivation à contrôler (8-1, ...., 8-n) est prévu pour détecter une variation de courant dans la dérivation, un dispositif de détection de défaut (2) pour détecter et évaluer des paramètres de réseau étant disposé entre la source de tension alternative (1) et les conducteurs d'alimentation (E1, E2), le dispositif de détection de défaut (2) étant adapté pour comparer des valeurs réelles des paramètres de réseau avec des valeurs de consigne prédéfinissables et pour détecter ainsi le conducteur d'alimentation (E1, E2) défectueux, et, en cas de survenance d'un écart pouvant être prédéfini par rapport aux valeurs de consigne, fait passer une commande (6) pour le commutateur de sélection (8) d'un état de repos à un état activé, la commande (6) assurant la liaison du conducteur d'alimentation défectueux (E1, E2) au potentiel de terre exclusivement pendant la durée de l'état activé, les dispositifs de détection (7) étant reliés à une unité de calcul (12) à laquelle sont transmis les résultats de mesure (S1, S2, S3, S4, Sz) détectés par les dispositifs de détection (7), l'unité de calcul (12) étant adaptée pour
- déduire des résultats de mesure (S1, S2, S3, S4, Sz) la hauteur d'au moins le courant de terre parasite capacitif (Ic1, Ic2, Ic3, Ic4, Icz) de la dérivation respective (8-1, ..., 8-n), et
- identifier la dérivation défectueuse (8-1, ..., 8-n) en détectant la variation d'au moins le courant capacitif parasite de terre (Ic1, Ic2, Ic3, Ic4, Icz) pendant la durée de la mise à la terre du conducteur d'alimentation défectueux (E1, E2).

7. Procédé selon la revendication 6, dans lequel la variation détectée d'au moins le courant est contrôlé selon des critères pouvant être prédéfinis et, en fonction du résultat, des mécanismes de protection de ligne associés aux dérivations (AZ1, AZ2, ...AZn) sont commandés.

8. Procédé selon la revendication 7, dans lequel la modification détectée d'au moins le courant est contrôlé selon des critères prédéfinissables et, en fonction du résultat, des mécanismes de protection de ligne associés aux dérivations (AZ1, AZ2, ...AZn) séparent automatiquement les dérivations (AZ1, AZ2, ...AZn) des conducteurs d'alimentation (E1, E2).

9. Procédé selon l'une des revendications 6 à 8, dans lequel la connexion de chaque conducteur d'alimentation (E1, E2) au potentiel de terre s'effectue selon une séquence temporelle prédéfinissable.

10. Procédé selon l'une des revendications 6 à 8, dans lequel les au moins deux conducteurs d'alimentation (E1, E2) sont contrôlés quant aux défauts d'isolation par rapport à la terre, et en ce que ce n'est qu'après avoir constaté un défaut d'isolation par rapport à la terre que les conducteurs d'alimentation (E1, E2) sont reliés au choix au potentiel de terre.

11. Procédé selon la revendication 10, dans lequel on relie exclusivement au potentiel de terre le conducteur d'alimentation (E1, E2) qui présente le défaut d'isolation par rapport à la terre.

12. Procédé selon l'une des revendications 6 à 11, **caractérisé en ce que** les dispositifs de détection (7) et l'unité de calcul (12) sont adaptés pour détecter également les composantes ohmiques et/ou inductives du courant de terre parasite et les utiliser pour la détection des défauts.
